# EUROPEAN PATENT APPLICATION

(11) **EP 1 069 210 A1**
(43) Date of publication of application: **17.01.2001**
(21) Application number: 00305866.6
(22) Date of filing: 12.07.2000
(51) Int. Cl.: C25D 3/38

(54) **Process for electrochemical deposition of high aspect ratio structures**

(30) Priority: 12.07.1999 US 143307 P; 12.07.2000 US 615038
(71) Applicant: Applied Materials, Inc., Santa Clara, California 95054 (US)
(72) Inventor: Duboust, Alain, Sunnyvale, CA 94086 (US); Gandikota. Srinivas, Santa Clara, CA 95051 (US); Neo, Siew, Santa Clara, CA 95051 (US); Chen, Liang-Yuh, Foster City, CA 94404 (US); Cheung, Robin, Cupertino, CA 95104 (US); Carl, Daniel, Pleasanton, CA 94566 (US)
(74) Representative: Allard, Susan Joyce

(57) **Abstract**

The present invention provides a method for void-free plating of a metal on a substrate having high aspect ratio apertures. The plating process is carried out in a solution containing metal at a molar concentration from about 0.2 M to about 1.2 M, an additive suppressor at a concentration from about 3.75 mL/L to about 15 mL/L of total solution, and an additive accelerator at a concentration from about 0.175 mL/L to about 2.1 mL/L of total solution. The temperature of the plating solution is less than 30°C.

## Description

### BACKGROUND OF THE INVENTION

### Field of the Invention

The present invention relates to new formulations of metal plating solutions designed to fill small features formed on substrates, *e.g.*, sub-micron scale features. More particularly, the invention relates to defect-free filling of the features with copper.

### Background of the Related Art

Copper has become a choice metal for filling sub-micron high aspect ratio interconnect features on substrates as circuit densities increase for the next generation of ultra large scale integration because copper and its alloys have lower resistivity than aluminum and significantly higher electromigration resistance as compared to aluminum. These characteristics are important for supporting the higher current densities experienced at high levels of integration and increased device speed.

The aspect ratios for the features, *i.e.*, the ratio of the feature height to the feature width, increases with each generation of integration. Many traditional deposition processes have difficulty filling structures where the aspect ratio exceeds 4:1, and particularly where it exceeds 10:1 and has a width less than 350 nanometers wide. Additionally, as the feature widths decrease, the interconnect features experience increased current densities that require void-less formation of the metal within the interconnect feature. Thus, there is a great amount of ongoing research and development being directed at the formation of void-free, sub-micron features having high aspect ratios.

Despite the desirability of using copper for semiconductor device fabrication, choices of fabrication methods for depositing copper into very high aspect ratio features are limited because common chemical vapor deposition processes and physical vapor deposition processes have provided unsatisfactory results. Electrodeposition of metals has been identified as a promising deposition technique in the manufacture of integrated circuits and flat panel displays and is being projected as an economical and viable solution for future copper interconnect needs. Therefore, much effort is being focused in this area to design hardware and chemistry to achieve high quality films on substrates which are uniform across the area of the substrate and which can fill or conform to very small features.

Typically, the chemistry, *i.e.,* the chemical formulations and conditions, used in conventional plating cells is designed to provide acceptable plating results when used in many different cell designs, on different plated parts, and in numerous different applications. Cells which are not specifically designed to provide highly uniform current density (and the deposit thickness distribution) on specific plated parts require high conductivity solutions to be utilized to provide high 'throwing power' (also referred to as high Wagner number) so that good coverage is achieved on all surfaces of the plated object. Typically, a supporting electrolyte, such as an acid or a base, and conducting salt, are included in the plating solution to provide the high ionic conductivity to the plating solution necessary to achieve high 'throwing power'. The supporting electrolyte does not participate in the electrode reactions, but reduces the resistivity within the electrolyte to provide conformal coverage of the plated material over the surface of the object. The higher resistivity that otherwise occurs may cause non-uniformity in the current density over a plating surface.

A problem encountered with conventional plating solutions is that the deposition process on small features is controlled by mass transport (diffusion) of the reactants to the feature and by the kinetics of the electrolytic reaction instead of by the magnitude of the electric field as is common on large features. In other words, the replenishment rate at which plating ions are provided to the surface of the object can limit the plating rate, irrespective of voltage or current density applied to the plating surface. Hence, highly conductive electrolyte solutions that provide conventional "throwing power" have little significance in obtaining good coverage and fill within very small features. Moreover, in the presence of excess acid or base supporting electrolyte (even a relatively small excess), the transport rates are diminished by approximately one half (or the concentration depletion is about doubled for the same current density), which may cause a reduction in the quality of the deposit and may lead to fill defects, particularly on small features.

Most copper plating solutions used in electrodeposition are multi-component systems comprising copper electrolyte, suppressers, and accelerators or brighteners. Suppressors and accelerators compete for adsorption sites on a plating surface. Suppressers (hereinafter additive "Y") inhibit or reduce copper deposition in the adsorbed areas, while brighteners or accelerators (hereinafter additive "X") accelerate copper growth in the adsorbed areas. One problem encountered as a result of this competition for adsorption sites is that the accelerator may accumulate at the mouth of the via/trench and close the mouth of the via/trench before the via/trench is completely filled, thus creating a void in the via/trench. Another problem is that various parameters such as temperature, electrode voltage, and acidity of the solution affect the desired ability of the suppressers and accelerators to provide bottom up coverage of a feature.

As a consequence of these chemical limitations in electro-chemical deposition, there is a need for a method for plating a metal in small features, *e.g.*, sub-micron scale and smaller features, on substrates that provide defect-free fill of such small features.

### SUMMARY OF THE INVENTION

The present invention provides a method for plating a metal on a substrate having high aspect ratio apertures, comprising disposing the substrate and an anode in a suppressed plating solution, the solution comprising metal ions at a molar concentration from about 0.2 M to about 1.2 M, an additive suppressor at a concentration from about 3.75 mL/L to about 25 mL/L of total solution, and an additive accelerator at a concentration from about 0.175 mL/L to about 5 mL/L of total solution. The metal is electrodeposited onto the substrate without forming voids within features on the substrate. The plating solution has a pH less than about 2.75, preferably a pH less than about 1.6. The temperature of the plating solution is generally less than about 30°C, preferably between about 15°C to about 20°C. Defect-free filling of the features is enhanced at higher flow rates of the plating solution, such as a flow rate greater than 2 gallons per minute (gpm) for an 8 inch substrate.

Another aspect of the present invention selects the wafer loading voltage applied to the substrate as the substrate is immersed in the plating solution. For plating solutions having a pH of about 1.6 or higher, filling of the features may be enhanced at a wafer loading voltage of about -0.4 V, whereas, for plating solution having a pH less than about 1, filling of the features was enhanced at a wafer loading voltage of about -0.8 V.

### DETAILED DESCRIPTION OF THE PREFERRED EMBODIMENT

The present invention generally provides a deposition process for void-free filling of interconnect features having high aspect ratios, *e.g.*, >4:1, on a substrate. Interconnect features are typically formed in a dielectric layer on a substrate. A conformal barrier layer is typically deposited over the dielectric layer, including surfaces of the interconnect feature, to prevent diffusion of copper into adjacent layers, typically silicon dioxide, silicon, or other dielectric materials. Barrier layers for copper applications are available for interlayer dielectric applications, and may include materials such as titanium (Ti), titanium nitride (TiN), tantalum (Ta), tantalum nitride (TaNₓ), tungsten (W), tungsten nitride (WNₓ), or a combination of these layers. The most preferred barrier materials are Ta and/or TaN, which is typically provided as a PVD layer. The barrier layer is deposited to form a substantially continuous cap over the dielectric layer and may be treated with nitrogen to improve barrier properties or adhesion to adjacent layers. A conformal metal seed layer is deposited over the barrier layer to facilitate electroplating. For electrochemical deposition of copper, the seed layer may include a copper seed layer deposited by PVD or CVD process.

The process of the invention comprises disposing the substrate (biased as cathode) and an anode in a suppressed plating solution, and then plating metal ions in the solution onto the substrate. The plating solution comprises metal ions at a molar concentration from about 0.2 M to about 1.2 M, an additive suppressor at a concentration from about 3.75 mL/L to about 25 mL/L of total solution, and an additive accelerator at a concentration from about 0.175 mL/L to about 5 mL/L of total solution. The plating solution has a pH less than about 2.75, and the temperature of the plating solution is generally less than about 30°C. For an eight inch substrate, the plating solution is preferably introduced into an electro-chemical deposition cell at a flow rate greater than about 2 gallons per minute (gpm).

Experimental data presented below has several standard conditions and elements. An 8" substrate with a patterned dielectric layer of Si/SiO₂ thereon, received a conformal TaN barrier layer of thickness about 250Å deposited using a Vectra IMP source, available from Applied Materials, Inc., of Santa Clara, Calif., using process conditions recommended by the equipment manufacturer. A PVD Cu seed layer of thickness 2000Å was then deposited on the TaN barrier layer using a Electra Cu source, available from Applied Materials, Inc., of Santa Clara, Calif., using process conditions recommended by the equipment manufacturer.

For the experimental data presented below, the starting composition of the plating solution selected was 0.85M copper sulfate with a pH of about 2.75 after adding appropriate additives (suppressers and accelerators). The plating process was carried out on the Electra ECP system, available from Applied Materials, Inc. The temperature of the plating solution was varied from 15°C to about 25°C, while pH was varied from 2.75 to 0.5 to investigate its effect on via/trench fill. The additives, accelerator "X" and suppresser "Y", used were supplied by Lea Ronal (NY, USA) and are known as Electra plate X Rev 1.0 and Electra plate Y Rev 1.0, which are also known as SB additives. Scanning electron microscope (SEM) and focused ion beam (FIB) techniques were used to study the via/trench fill.

Typically, aqueous copper plating solutions comprised of copper sulfate, preferably from about 32 to about 192 grams per liter (g/L) of copper sulfate pentahydrate in water (H₂O), are employed as the electroplating solution. In addition to copper sulfate, the invention contemplates utilizing other copper salts, such as copper fluoroborate, copper gluconate, copper sulfarnate, copper sulfonate, copper pyrophosphate, copper chloride, copper cyanide and the like. Some of these copper salts offer higher solubility than copper sulfate, and therefore may be advantageous.

The deposition process on small features (*i.e.*, sub-micron) is controlled by mass transport (diffusion) of the reactants into the feature and by the kinetics of the electrolytic reaction instead of by the magnitude of the electric field. Therefore, the replenishment rate at which plating ions are provided to the surface of the feature can limit the plating rate, irrespective of voltage. Generally, plating rate increases with increasing material flow rate. Experimental data collected on gap fill of 4:1 aspect ratio vias at various flow rates indicate that better gap fill is achieved with higher flow rate. Thus, in order to obtain good quality deposition, mass-transport rates must be higher than the depletion rate of the reactant concentration near or within the small features.

A plating solution having a high copper concentration *(i.e.,* >0.4M) is beneficial to overcoming mass transport limitations when plating small features. In particular, because sub-micron scale features with high aspect ratios typically allow only minimal or no electrolyte flow therein, the ionic transport relies solely on diffusion to deposit metal into these small features. A high copper concentration in the electrolyte, typically in the range of about 0.2 M to about 1.2 M and preferably about 0.4 M or greater, enhances the diffusion process and reduces or eliminates the mass transport limitations. The metal concentration required for the plating process may depend on other factors such as temperature and the acid concentration of the electrolyte.

The copper plating electrolyte may include a sulfuric acid concentration from about 45 g of H₂SO₄ per L of H₂O (0.45M) to about 110 g/L (1.12M) to increase the conductivity of the electrolyte in the solution. The high conductivity may reduce the non-uniformity in the deposition thickness caused by the cell configuration and the differently shaped parts encountered in conventional electroplating cells.

The plating solution may contain suppressors and accelerators to assist in filling small features. Suppressors adsorb on the wafer surface and inhibit or reduce copper deposition in the adsorbed areas. Suppressors added in the plating solution may include two-element polyethylene glycol based suppressors, such as suppressors made of random/block copolymers of ethylene oxide and propylene oxide mixed in a wide range of ratios. Accelerators compete with suppressers for adsorption sites and accelerate copper growth in the adsorbed areas. The accelerators used in the plating solution may include sulphur containing compounds, such as sulfite or di-sulfate. Accelerators, with its smaller molecular dimension, can diffuse faster than suppressors. Since suppressers inhibit the copper growth, and the suppressers and accelerators are everywhere around the vias/trenches, a small overhang of the seed layer can close the mouth of the via/trench leading to a void in the via. Therefore, the most desired plating solution is one where the suppression is mostly active on the top of the topographical features and the accelerator dominate the suppressor in activity inside trenches or vias so as to achieve the bottom up growth. In one embodiment, the plating solution includes concentrations of accelerator from 0.175mL/L to 5mL/L and concentrations of suppressors from 3.75mL/L to 25mL/L.

Experimental data on the suppresser ("Y") and accelerator ("X") composition was collected on electro-chemical gap fill deposition fill in vias with various compositions of "X" and "Y". The data indicates that as the concentration of X increases in proportion to the concentration of Y, voidless gap fill performance worsens.

The activity of suppressers and accelerators depends on various parameters such as temperature, pH of plating solution, and chloride concentration in the plating solution. The temperature effect of the activities of the additives is related to the polarization dependence of these additives on temperature. A detailed study of gap fill in vias with various concentrations of "X" and "Y" indicates that a plating solution temperature of 15°C to 20°C yields a better void free fill of vias/trenches in moderate aspect ratio vias/trenches (an aspect ratio of 4:1). However, the temperature at which one can achieve this void free fill is expected to be different for different plating solution compositions and different additives in the plating solution.

Along with temperature, the pH of the plating solution also affects the quality of the void free fill. Experimental data indicates that gap fill results are improved by decreasing the pH of the plating solution, i.e., increasing the concentration of the sulfuric acid. The plating solutions of the invention may also contain halide ions, such as chloride, in concentrations of about 30 ppm to about 100 ppm.

The addition of suppressors and accelerators improves control of the deposition rates of electro-chemical solutions. Since the suppressers and accelerators tend to fill up the openings in vias/trenches as soon as the wafer comes into contact with the plating solution, any delay between the wafer immersion into the plating solution and the start of actual plating may lead to voiding in the features due to random distribution of the additives and the etching of the seed layer. To reduce such voiding activity, a wafer loading bias from about -0.2V to about -20V is applied to the substrate plating surface while the substrate is being immersed in the plating solution. Experimental data collected has indicated that applying a loading bias of about -0.4V for plating solutions with higher pH above 1.6 while loading the wafer provided a void free fill of the features. For plating solutions with pH less than 1.0, an immersion loading bias of about -0.8V or higher yields good void free fill. This observation can be related to the reduction of seed layer etching due to the acidic nature of plating solution and due to the associated polarization of the additives at these voltages.

Plating results may be enhanced by rotating the substrate as the substrate is immersed into the plating solution and during the plating process. The substrate may be loaded into the plating solution at a rotating speed from about 10 rpm to about 50 rpm. During plating, the substrate may be rotated at a speed from about 1 rpm to about 50 rpm. The plating process may be carried out at current densities ranging from about 2 mA/cm² to about 80 mA/cm². The plating process may be performed using a multi-step process wherein an initial current density between about 2 mA/cm² and about 20 mA/cm² is applied to the plating surface until the interconnect features are substantially filled, followed by a high current density between about 20 mA/cm² and about 80 mA/cm² applied to the plating surface to complete formulation of a metal layer on the substrate. The initial low current density provides conformal plating over the plating surface and void free filling of features. After the features have been substantially filled, the current density applied to the plating surface may be increased to increase the plating rate and reduce the process time for completing deposition of the metal layer on the substrate.

While the foregoing is directed to the preferred embodiment of the present invention, other and further embodiments of the invention may be devised without departing from the basic scope thereof, and the scope thereof is determined by the claims that follow.

## Claims

1. A method for plating a metal on a substrate having high aspect ratio apertures, the method comprising:
disposing the substrate and an anode in a plating solution comprising metal ions at a molar concentration from about 0.2 M to about 1.2 M, an additive suppressor at a concentration from about 3.75 mL/L to about 25 mL/L of total solution, and an additive accelerator at a concentration from about 0.175 mL/L to about 5 mL/L of total solution; and
plating metal ions in the plating solution onto the substrate.

2. The method of claim 1, wherein the plating solution has a pH of less than about 2.75.

3. The method of claim 1 or claim 2, wherein the plating solution has a pH of less than about 1.6.

4. The method of any one of claims 1 to 3, wherein the plating solution is at a temperature of less than about 30°C.

5. The method of any one of claims 1 to 4, wherein the plating solution is at a temperature from about 15°C to about 20°C.

6. The method of any one of claims 1 to 5, wherein the plating solution comprises metal ions at a molar concentration of about 0.85 M.

7. The method of any one of claims 1 to 6, wherein the metal ions are copper ions.

8. The method of any one of claims 1 to 7, further comprising biasing the substrate with a loading bias between about -0.2 V to about -20 V as the substrate is immersed into the plating solution.

9. The method of any one of claims 1 to 8, further comprising rotating the substrate at a speed between about 10 rpm to about 50 rpm as the substrate is immersed into the plating solution.

10. The method of claim 9, further comprising rotating the substrate at a speed between about 1 rpm to about 50 rpm during plating.

11. The method of any one of claims 1 to 10, wherein the plating solution contains halide ions.

12. The method of any one of claims 1 to 11, wherein the plating solution contains chlorine having a concentration between about 30 ppm to about 100 ppm.

13. The method of any one of claims 1 to 12, wherein the substrate is biased with a current density between about 2 mA/cm² to about 80 mA/cm² during plating.

14. The method of any one of claims 1 to 13, wherein the substrate is initially biased at a first current density between about 2 mA/cm² to about 20 mA/cm², followed by a second current density between about 20 mA/cm² to about 80 mA/cm².

15. The method of any one of claims 1 to 14, wherein the suppressor comprises a mixture of polyethylene glycols.

16. The method of any one of claims 1 to 15, wherein the suppressor comprises copolymers of ethylene oxide to propylene oxide.

17. The method of any one of claims 1 to 16, wherein the accelerator is a sulphur containing compound.

18. The method of any one of claims 1 to 17, wherein the plating solution has a flow rate greater than about 2 gallons per minute.
